# EUROPEAN PATENT APPLICATION

(11) **EP 2 031 645 A1**
(43) Date of publication of application: **04.03.2009**
(21) Application number: 07016860.4
(22) Date of filing: 28.08.2007
(51) Int. Cl.: H01L 21/304, B08B 1/04, B24B 37/04

(54) **Device for elevating up and down cleaning brush of chemical-mechanical wafer polishing apparatus**

(71) Applicant: DOOSAN MECATEC CO., LTD., Gyeongsangnam-do 641-370 (KR)
(72) Inventor: Seo, Chang Won, Taean-eup, Hwaseong-si, Gyeonggi-do 445-360 (KR); Yoon, Jung Hwan, Jangan-gu, Suwon-si, Gyeonggi-do 440-734 (KR)
(74) Representative: Stolmár, Matthias

(57) **Abstract**

Disclosed is a device for elevating up and down a cleaning brush of a chemical mechanical wafer polishing apparatus, which elevates up and down the cleaning brush for cleaning alien substances on the wafer, which includes a fame; a reference brush rotatably supported by the frame; an elevation block installed at the frame in such a manner that the elevation block can be elevated up and down; an elevating brush rotatably installed at the elevation block, the elevating brush being elevated along with the elevation block while approaching or being spaced from the reference brush; and a linear motor for elevating the elevation block. It is possible to reduce a unit cost of product, production cost, and production time. Furthermore, there is an advantage in size-reduction and weight-reduction, and elevation driving can be accurately controlled.

## Description

### BACKGROUND OF THE INVENTION

### 1. Field of the invention

The present invention relates to a chemical-mechanical wafer polishing apparatus, and more particularly to a device for elevating up and down a cleaning brush of a chemical-mechanical wafer polishing apparatus, which can accurately control elevation of the cleaning brush for a polished wafer.

### 2. Description of the Prior Art

A semiconductor wafer manufacturing process includes a wafer surface polishing process for polishing a surface of a wafer while rotating the wafer at a high speed by using a chemical mechanical polishing (CMP) apparatus, etc. Such a wafer surface polishing process has to include a wafer cleaning process for removing alien substances or particles, etc. which are generated in a process for polishing a wafer. An embodiment of a cleaning device used for such a wafer cleaning process is disclosed in Korea Patent Laid-Open Publication No. 2005-82323.

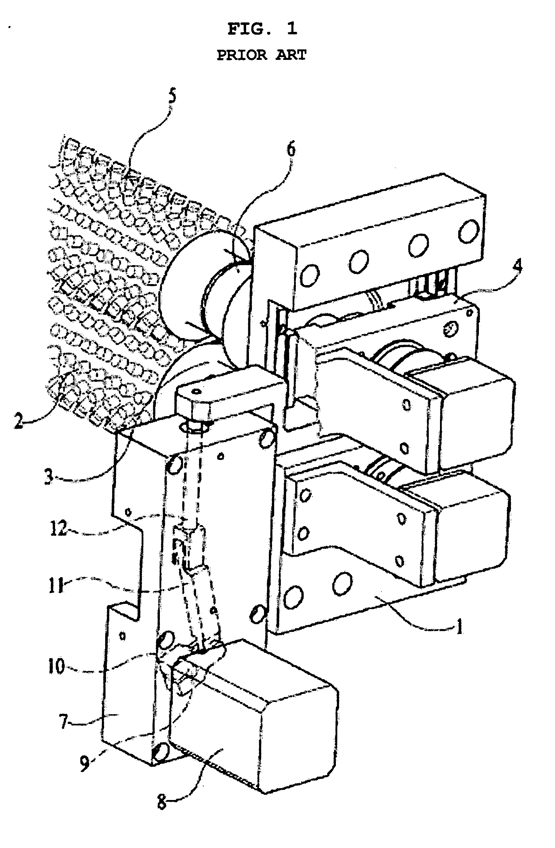

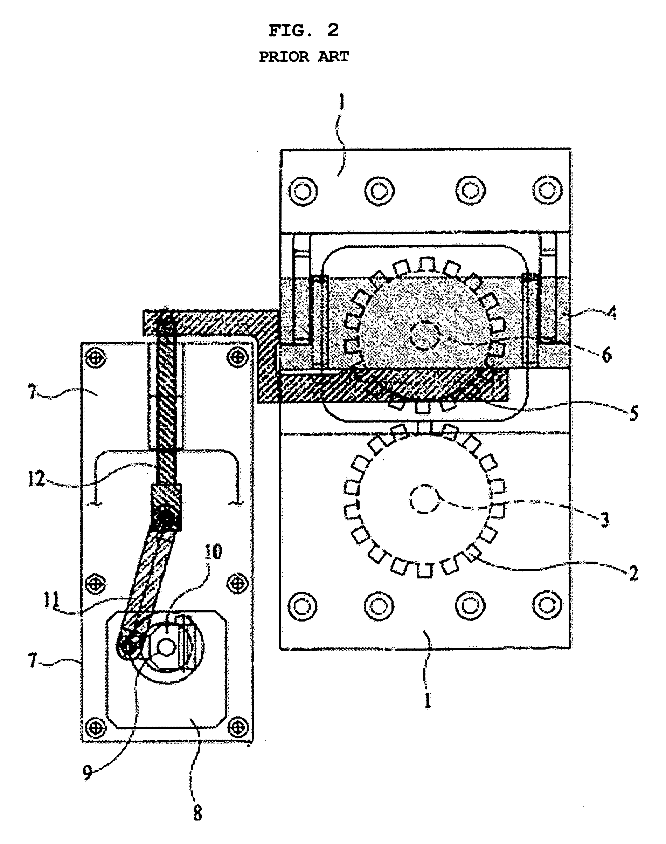

A main part of the cleaning device disclosed in the Patent Laid-Open Publication is schematically illustrated in FIGs. 1 and 2.

With reference to FIGs. 1 and 2, the cleaning device makes contact with a front surface and a rear surface of a wafer which is rotated by a guide roller (not shown), and includes a pair of cleaning brushes 2 and 5 which are made of sponge material having moisture-retaining property and performs relative movement with respect to the wafer.

The distance between the cleaning brushes 2 and 5 has to be adjusted according to the kind of chemical to be injected on the wafer in order to clean the wafer or according to the type of wafer. Therefore, a device for elevating up and down a cleaning brush for elevating up and down one of the cleaning brushes 2 and 5 is required.

The device for elevating up and down a cleaning brush includes a frame 1, a reference brush 2, an elevating block 4, an elevating brush 5, a guide block 7, a rotating motor 8, a crank 10, a link arm 11, and an elevating rod 12.

The frame 1 is used to support the above-described components. The reference brush 2 is rotatably supported by the frame 1, and the elevation block 4 is supported by the frame 1 in such a manner that the elevation block 4 can be elevated up and down.

The reference brush 2 is rotatably supported by a lower side of the frame 1. More particularly, the rotational shaft 3 of the reference brush 2 is rotatably supported by the frame 1.

The elevation block 4 is installed at an upper side of the frame 1 so as to be elevated up and down.

The rotational shaft 6 of the elevating brush 5 is rotatably supported at the elevation block 4. Therefore, the elevating brush 5 is elevated up respective to the reference brush 2 according to movement of the elevation block 4 in upper and lower directions.

The guide block 7 supports the rotating motor 8, the crank 10, the link arm 11, and the elevating rod 12, and guides the elevation movement of the elevating rod 12.

The crank 10 is coupled with a rotational shaft 9 of the rotational motor 8 so as to rotate about the rotational shaft 9. The link arm 11 has one end coupled with one end of the crank 10 and the other end thereof linked with the elevating rod 12 so as to change rotational movement of the crank 10 into reciprocal linear movement of the elevating rod 12.

The elevating rod 12 is restricted by the guide block 7 so as to perform only reciprocal linear movement, and an upper end thereof is connected with the elevation block 4. Particularly, when the elevating rod 12 is moved linearly and reciprocally by the link arm 11, the elevation block 4 performs elevation movement by the elevating rod 12. As a result, the elevating brush 5 performs elevation movement respective to the reference brush 2.

However, the above-described conventional device for elevating up and down a cleaning brush of a chemical-mechanical wafer polishing apparatus has disadvantages hereinafter.

Firstly, the conventional device for elevating up and down a cleaning brush requires too many components such as the crank 10, the link arm 11, and the elevating rod 12, etc., so as to change rotational movement of a motor into a reciprocal linear movement, and also requires a complicated construction, such as the guide block 7, thereby wasting a large amount of the cost of product, production cost, and production time.

Secondly, in the conventional device for elevating up and down a cleaning brush, in a procedure of changing rotational movement into linear movement, the pulse of a motor is controlled using an approximate value obtained by dividing the total elevation distance by a predetermined interval. Therefore, the control process is complicated, and the degree of accuracy in the elevation movement is degraded. Furthermore, as described-above, due to manufacturing errors of many components used to change rotational movement into linear movement, etc., accuracy in controlling elevation position according to rotational angel of the motor decreases more and more.

Thirdly, in the conventional device for elevating up and down a cleaning brush, volume occupied by the guide block 7, etc. and weight thereof are large. Therefore, there is a difficulty in size-reduction, weight-reduction, and it is complicated to control, exchange, and repair components thereof.

### SUMMARY OF THE INVENTION

Accordingly, the present invention has been made to solve the above-mentioned problems occurring in the prior art, and the present invention provides a device for elevating up and down a cleaning brush of a chemical mechanical wafer polishing apparatus, which omits components used to change rotational movement into linear movement by employing a linear motor, thereby reducing the cost of product, production cost, and production time, and which minimizes manufacturing errors between components so that position control is accurately performed, and which has an apparatus having an advantage in size-reduction and weight-reduction and can be easily controlled and repaired by exchanging components thereof, etc.

In accordance with an aspect of the present invention, there is provided a device for elevating up and down a cleaning brush of a chemical-mechanical wafer polishing apparatus, which elevates up and down the cleaning brush for cleaning alien substances on the wafer, which includes: a frame; a reference brush rotatably supported by the frame; an elevation block installed at the frame in such a manner that the elevation block can be elevated up and down; an elevating brush rotatably installed at the elevation block, the elevating brush being lifted along with the elevation block while approaching or being spaced from the reference brush; and a linear motor for driving the elevation block to be lifted.

In accordance with another aspect of the present invention, there is provided a device for elevating up and down a cleaning brush of a chemical-mechanical wafer polishing apparatus, which further includes: a mount plate which is fixedly coupled with the elevation block and has a hole into which a part of the motor rod is inserted; a fixing member fixed in the part of the motor rod, which is inserted into the hole so that the motor rod is fixed in the mount plate; a shaft supporting block which is fixedly installed at the frame and by which a rotational shaft of the reference brush is rotatably supported; and an elevating shaft supporting block which is fixedly installed at the elevation block and by which a rotational shaft of the elevating brush is rotatably supported.

In accordance with another aspect of the present invention, there is provided a device for elevating up and down a cleaning brush of a chemical-mechanical wafer polishing apparatus, which includes: a first brush rotatably installed at a frame so as to perform relative movement with respect to a wafer while making contact with one surface of the wafer; a second brush which is installed at the frame in such as manner that the second brush can rotate and move up and down so as to perform relative movement with the wafer while making contact with the other surface of the wafer; and a linear motor for driving the second brush to be lifted so as to control an distance between the first brush and second brush.

### BRIEF DESCRIPTION OF THE DRAWINGS

The above and other objects, features and advantages of the present invention will be more apparent from the following detailed description taken in conjunction with the accompanying drawings, in which:
FIG. 1 is a schematic perspective view of a device for elevating up and down a cleaning brush of a conventional chemical mechanical wafer polishing apparatus;
FIG. 2 is a lateral sectional view of FIG. 1;
FIG. 3 is a schematic perspective view of a device for elevating up and down a cleaning brush of a chemical mechanical wafer polishing apparatus according to one embodiment of the present invention; and
FIG. 4 is a lateral sectional view of FIG. 3.

### DETAILED DESCRIPTION OF THE EXEMPLARY EMBODIMENTS

Hereinafter, a device for elevating up and down a cleaning brush of a chemical mechanical wafer polishing apparatus according to one embodiment of the present invention will be described in detail with reference to the accompanying drawings.

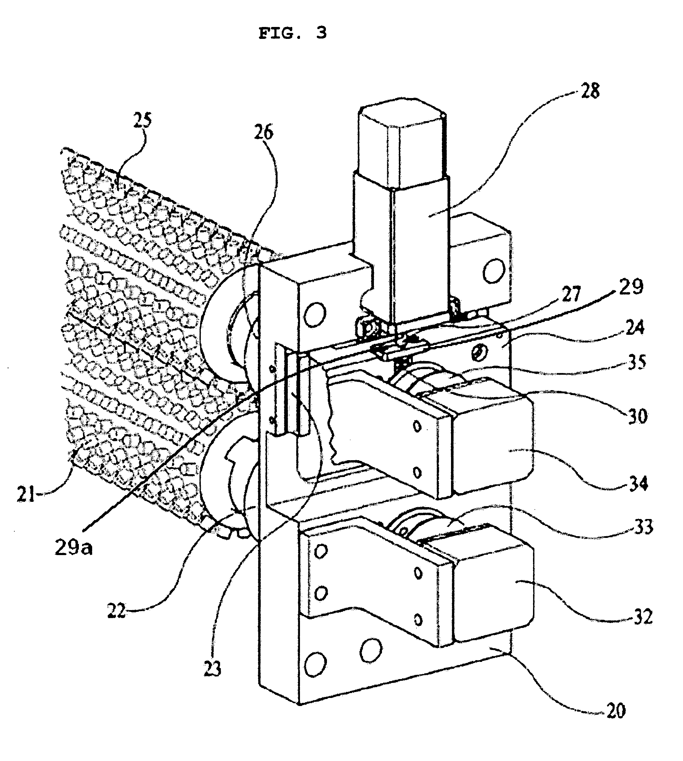

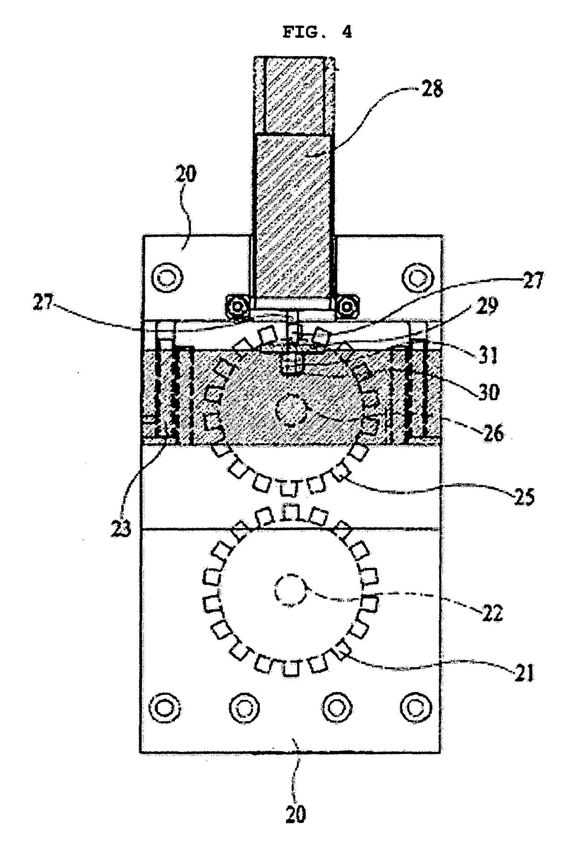

With reference to FIGs. 3 and 4, a device for elevating up and down a cleaning brush of a chemical mechanical wafer polishing apparatus according to one embodiment of the present invention is used to elevate one of cleaning brushes 21 and 25 for cleaning alien substances of a wafer in a C.M.P apparatus for polishing a wafer, and includes a frame 20, a first brush, i.e. a reference brush 21, an elevation block 24, a second brush, i.e. an elevating brush 25, and a linear motor 28.

The frame 20 serves to support the above-described components. The reference brush 21 is rotatably supported by the frame 20, the elevation block 24 is supported by the frame 20 so as to be elevated up and down, and the linear motor 28 is fixedly installed at the frame 20.

The reference brush 21 has a rotational shaft 22 rotatably installed at a lower side of the frame 20 so that the reference brush 21 is rotated about the rotational shaft 22 at the frame 20.

The elevation block 24 is installed at an upper side of the frame 20 in such as manner that the elevation block 24 can elevated up and down. More particularly, a guide groove (not shown) is formed at the elevation block 24 in upper and lower directions, and an elevating guide rail 23 to be inserted into the guide groove is formed at the frame 20. The guide rail 23 is inserted into the guide groove so that elevation movement of the elevation block 24 is guided. Of course, the above-described structure is an embodiment of a structure for guiding elevation movement of the elevation block 24, it would be easily understood that various guide means may be employed as long as they can guide the elevation block 24 in upper and lower directions.

The elevating brush 25 has a rotational shaft 26 rotatably supported by the elevation block 24 so as to perform elevation movement along with the elevation block 24. As the elevating brush 25 performs elevation movement, the elevating brush 25 and the reference brush 21 approach each other or are spaced from each other. Accordingly, the distance between the reference brush 21 and the elevating brush 25 can be adjusted.

The linear motor 28 is fixedly installed at the frame 20, and a motor rod 27 of the linear motor 28 is connected with the elevation block 24 so as to elevate up and down the elevation block 24. The linear motor 28 is accurately controlled by a pulse wave or driving signals, etc., so that reciprocal linear movement of the motor rod 27 can be controlled.

Due to such the linear motor 28, it is possible to omit complicated components used in order to change rotational movement into linear movement, such as the crank 10, the link arm 11, the elevating rod 12, and the guide block 7, etc., as shown in FIGs. 1 and 2.

The motor rod 27 has to be fixedly connected with the elevation block 24. For this structure, a mount plate 29 having a hole 29a extending through the mount plate 29, into which a part of the motor rod 27 is inserted, is fixedly installed at the elevation block 24, and fixing members 30 such as screws or bolts, etc. are fastened in the part of the motor rod 27, which is inserted into the hole 29a. Accordingly, the motor rod 27 is fixedly installed at the elevation block 24 so that the elevation block 24 can be elevated up and down.

Meanwhile, a reference shaft supporting block 32 for supporting a rotational shaft 22 of the reference brush 21 is fixedly installed at the frame 20, and a timing pulley 33 is installed at the rotational shaft 22 of the reference brush 21.

Furthermore, an elevating shaft supporting block 34, by which the rotational shaft 26 of the elevating brush 25 is supported, is fixedly installed at the elevation block 24, and a timing pulley 35 is installed at the rotational shaft 26 of the elevating brush 25.

The timing pulleys 33 and 35 are connected by a timing belt, which is not shown. According to the above-described structure, the reference brush 21 and the elevating brush 25 can be accurately rotated along with each other.

Hereinafter, the operating process of the device for elevating up and down a cleaning brush as described above will be described. When a linear motor 28 is driven so that the motor rod 27 is elevated up and down, the elevation block 24 connected with the motor rod 27 performs elevation movement along the elevating guide rail 23.

As such, due to a linear motor 28 which is easily and accurately controlled, it is possible to omit components used in order to change rotational movement into linear movement, thereby reducing the cost of a product, production cost, and production time. Furthermore, size-reduction and weight-reduction of an apparatus can be realized, and it can be easy to control or repair the linear motor 28 and to change components thereof. Also, an initial position of the elevation block 24 can be accurately adjusted. Therefore, damage to a wafer or a driving error can me minimized.

Although an exemplary embodiment of the present invention has been described for illustrative purposes, those skilled in the art will appreciate that various modifications, additions and substitutions are possible, without departing from the scope and spirit of the invention as disclosed in the accompanying claims.

## Claims

1. A device for elevating up and down a cleaning brush of a chemical mechanical wafer polishing apparatus, which elevates up and down the cleaning brush for cleaning alien substances on the wafer, comprising:
a frame;
a reference brush rotatably supported by the frame;
an elevation block installed at the frame in such a manner that the elevation block can be elevated up and down;
an elevating brush rotatably installed at the elevation block, the elevating brush being elevated along with the elevation block so that the elevating brush approaches or is spaced from the reference brush; and
a linear motor elevating up and down the elevation block.

2. The device for elevating up and down a cleaning brush of a chemical mechanical wafer polishing apparatus, as claimed in claim 1, wherein a motor rod of the linear motor is fixedly installed at the elevation block.

3. The device for elevating up and down a cleaning brush of a chemical mechanical wafer polishing apparatus, as claimed in claim 2, comprising:
a mount plate which is fixedly coupled with the elevation block and has a hole into which a part of the motor rod is inserted; and
a fixing member fixed in the part of the motor rod inserted into the hole so as to fix the motor rod in the mount plate.

4. The device for elevating up and down a cleaning brush of a chemical mechanical wafer polishing apparatus, as claimed in claim 3, comprising:
a reference shaft supporting block which is fixedly installed at the frame and rotatably supports a rotational shaft of the reference brush; and
an elevating shaft supporting block which is fixedly installed at the elevation block and rotatably supports a rotational shaft of the elevating brush.

5. A device for elevating up and down a cleaning brush of a chemical mechanical wafer polishing apparatus, comprising:
a first brush rotatably installed at a frame so as to perform a relative movement with respect to a wafer while making contact with one surface of the wafer;
a second brush which is installed at the frame in such as manner that the second brush can be rotated and elevated up and down so as to perform a relative movement with respect to the wafer while making contact with the other surface of the wafer; and
a linear motor elevating the second brush so as to control a distance between the first brush and second brush.
